## Europäisches Patentamt
## European Patent Office
## Office européen des brevets

(19)

(11) Numéro de publication: **0 206 865 B1**

(12) **FASCICULE DE BREVET EUROPEEN**

(45) Date de publication du fascicule du brevet: 26.07.89

(51) Int. Cl.⁴: **H01L 43/08, G11B 5/39**

(21) Numéro de dépôt: 86401117.6

(22) Date de dépôt: 27.05.86

(54) **Capteur à effet magnéto-résistif linéaire, son procédé de réalisation et son application dans un détecteur de domaines magnétiques.**

(30) Priorité: 30.05.85 FR 8508162

(43) Date de publication de la demande:
30.12.86 Bulletin 86/52

(45) Mention de la délivrance du brevet:
26.07.89 Bulletin 89/30

(84) Etats contractants désignés:
**DE GB IT NL**

(56) Documents cités:
**US-A- 3 898 359**

**PATENTS ABSTRACTS OF JAPAN,
vol. 7, no. 292 (E-219)[1437], 27 décembre 1983 & JP - A
- 58 166 781
THIN SOLID FILMS,
vol. 100, no. 2, février 1983, pages 81-109, Elsevier
Sequoia, Lausanne, CH; R.M. MEHRA et al.:
"Magnetoresistance in amorphous semiconductors"**

(73) Titulaire: **THOMSON-CSF, 51, Esplanade du Général de Gaulle, F-92800 Puteaux(FR)**

(72) Inventeur: **Meunier, Paul-Louis c/o Thomson-CSF SCPI, 19, avenue de Messine, F-75008 Paris(FR)**
Inventeur: **Huijer, Ernst c/o Thomson-CSF SCPI, 19, avenue de Messine, F-75008 Paris(FR)**
Inventeur: **Razeghi, Manijeh c/o Thomson-CSF SCPI, 19, avenue de Messine, F-75008 Paris(FR)**
Inventeur: **Lehureau, Jean-Claude c/o Thomson-CSF SCPI, 19, avenue de Messine, F-75008 Paris(FR)**

(74) Mandataire: **Lepercque, Jean et al, THOMSON-CSF SCPI, F-92045 PARIS LA DEFENSE CEDEX 67(FR)**

## Description

L'invention concerne un capteur à effet magnéto résistif, son procédé de réalisation et son application à un détecteur de domaines magnétiques. Un tel détecteur peut être utilisé pour la lecture de supports d'informations magnétiques et permet de lire simultanément un ensemble d'informations.

Les capteurs utilisant l'effet magnéto résistif linéaire (MRL) dans un matériau semi-conducteur (InSBO) sont connus, p.ex. du document US-A 3 898 359.

On considère une couche mince de semiconducteur (quelques microns) dans laquelle circule un fort courant. Lorsqu'ils sont soumis à un champ magnétique perpendiculaire au courant dans le plan de la couche, les porteurs (électrons et trous) sont défléchis perpendiculairement à la couche et dans le même sens. L'effet Hall classique suppose que les courants des deux porteurs sont différents. Les forces appliquées aux porteurs majoritaires sont annulées par le champ de Hall. Dans l'effet MRL les courants sont équilibrés, aucun champ ne s'oppose à la déflexion des porteurs qui s'amassent sur l'une des surfaces délimitant la couche. Les vitesses de recombinaison sur chacune de ces surfaces sont choisies très différentes de manière à ce que la concentration moyenne de porteurs dans la couche soit augmentée ou diminuée suivant le sens du champ magnétique. La résistance de la couche au courant injecté varie linéairement avec le champ magnétique.

Actuellement, cet effet est trop faible pour pouvoir réaliser la lecture d'informations enregistrées sur des supports magnétiques, tels qu'une bande magnétique, dont les bits inscrits développent des champs magnétiques de trop faible valeur. En effet, un champ de fuite de quelques dizaines de Gauss (1 G = $10^{-4}$T) à une distance de 3 µm à 5µm ne suffit pas à induire un courant suffisant dans la couche de semiconducteur. Il faut un champ de plusieurs centaines de Gauss.

C'est pourquoi l'invention fournit un capteur permettant d'amplifier et de lire des informations magnétiques donc les champs magnétiques de faibles intensités telles que des informations enregistrées sur bandes magnétiques ou dans des mémoires à bulles magnétiques.

L'invention concerne donc un capteur à effet magnéto résistif linéaire, caractérisé en ce qu'il comprend : une couche d'un matériau semi-conducteur comportant une première face et une deuxième face ; une couche d'un matériau ferrimagnétique recouvrant la première face de la couche de matériau semi-conducteur ; au moins un couple d'électrodes disposé sur la deuxième face de la couche de matériau semi-conducteur.

L'invention concerne également un procédé de réalisation d'un capteur à effet magnéto résistif, caractérisé en ce qu'il comporte les différentes phases suivantes :

a) une première phase de dépôt d'une couche d'un matériau ferrimagnétique sur un premier substrat ;

b) une deuxième phase de dépôt d'une couche d'un matériau semi-conducteur sur la couche de matériau ferrimagnétique ;

c) une troisième phase de dépôt d'électrodes sur la couche de matériau semi-conducteur ;

d) une quatrième phase de fixation du composant obtenu sur un deuxième substrat en matériau isolant par la face portant les électrodes ;

e) une cinquième phase d'enlèvement de tout ou partie du premier substrat.

Enfin, l'invention concerne également un détecteur de domaines magnétiques comportant un support magnétique comportant au moins un domaine induisant un champ magnétique selon une première direction déterminée, caractérisé en ce qu'il comporte également un capteur comprenant principalement :
- une couche d'un matériau semi-conducteur comportant une première et une deuxième face ;
- une couche d'un matériau ferrimagnétique déposée sur la première face du matériau semi-conducteur ;
- au moins un couple de deux électrodes disposées sur la deuxième face du matériau semi-conducteur, selon une deuxième direction ; ledit capteur étant disposé de telle façon que sa face portant la couche de matériau ferrimagnétique soit à proximité du support magnétique et que la deuxième direction des deux électrodes soit perpendiculaire à la première direction du champ magnétique.

Les différents objets et caractéristiques seront détaillés dans la description qui va suivre, faite en se reportant aux figures annexées qui représentent :

- les figures 1 à 5 un exemple de procédé de réalisation d'un capteur à effet magnéto résistif linéaire selon l'invention,
- la figure 6, un exemple de détecteur selon l'invention ;
- la figure 7, une variation de réalisation d'un détecteur selon l'invention ;
- la figure 8, une autre variante de réalisation d'un détecteur selon l'invention.

Un capteur réalisé selon l'invention comporte, comme cela est représenté en figure 5, une couche d'un matériau semi-conducteur 3, portant sur l'une de ses faces, une couche d'un matériau ferrimagnétique 2 et, sur la face opposée à la première, des couples tels que 4 d'électrodes 41, 42. Les connexions des électrodes 41 et 42 vers des circuits d'utilisation tels que des circuits à transfert de charge (CCD ou Charge Coupled device par exemple, en terminologie anglo-saxonne), ne sont pas représentées. L'ensemble est monté collé sur une pièce support 5 assurant une rigidité et un maintien du composant ainsi décrit.

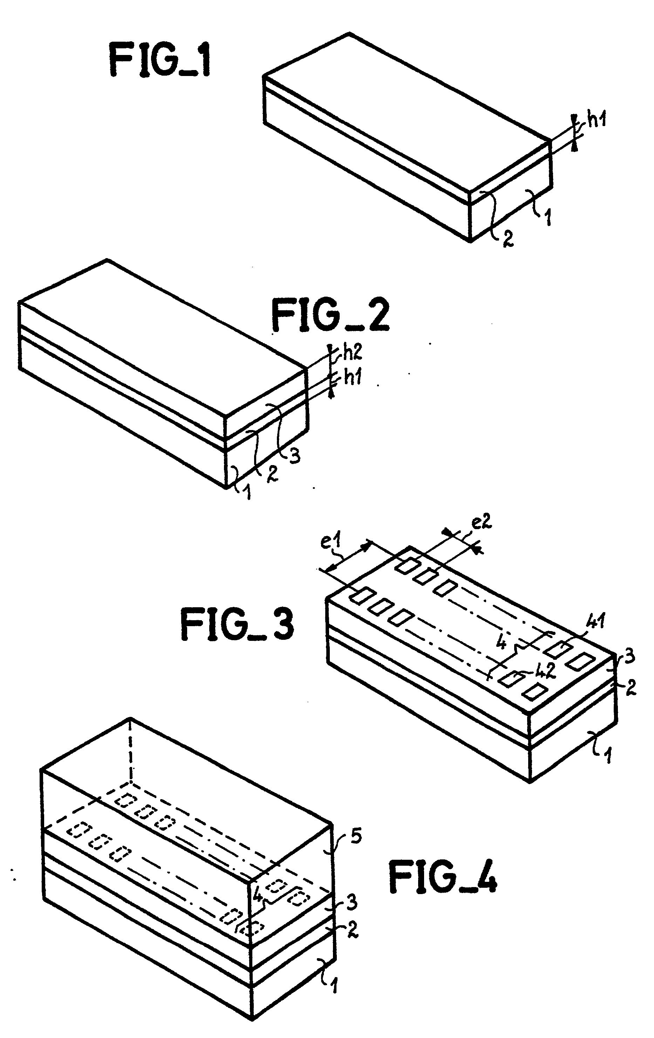

En se reportant aux figures 1 à 5, on va maintenant décrire un exemple de procédé de réalisation d'un capteur selon l'invention.

Au cours d'une première phase, sur un substrat 1 de forme plane réalisé dans du grenat de gadolinium et gallium (GGG) on effectue une croissance d'un matériau ferrimagnétique tel qu'un grenat d'Yttrium et de Fer (YIG).

Cette croissance peut se faire soit par épitaxie en phase liquide à une température de 980 degrés Celsius à la pression atmosphérique, soit par épitaxie en phase vapeur à une température comprise entre 400 et 700 degrés Celsius sous une pression de 50 à 500 millibars, soit enfin, par pulvérisation cathodique également désignée par "SPUTTERING" en terminologie anglo-saxonne.

L'épaisseur h1 de la couche de matériau ferrimagnétique 2 ainsi obtenue doit être d'environ 3 microns. On obtient ainsi une plaquette telle que représentée en figure 1.

Au cours d'une deuxième phase, on réalise un dépôt d'une couche d'un matériau semi-conducteur 3 sur la couche 2 précédente, (figure 2). On choisira un matériau semi-conducteur constitué d'éléments des classes III et V (ou II et VI) de la classification périodique des éléments. Le paramètre de maille sera un sous-multiple de celui du matériau ferrimagnétique 2 ou présentera une surface de maille compatible avec celle de ce matériau.

Ce dépôt peut se faire par un procédé d'épitaxie en phase vapeur (CVD ou Chemical Vapor Deposition en terminologie anglo-saxonne) et plus précisément par épitaxie en phase vapeur d'organométalliques désigné par MOCVD (Metalorganic Chemical Vapor Deposition) en terminologie anglo-saxonne. L'épitaxie se fait à une température comprise entre 450 et 700 degrés Celsius sous une pression comprise entre 50 millibars et 500 millibars. La vitesse de dépôt pour que l'adaptation entre le matériau épitaxié et la couche 2 se fasse correctement est choisie de préférence entre 20 Angstroems et 300 Angstroems par minute l'épaisseur h2 de la couche obtenue doit être comprise entre 5 et 10 microns. On obtient ainsi une plaquette telle que représentée en figure 2.

Au cours d'une troisième phase on dépose, par tout procédé connu dans la technique, sur la surface libre de la couche 3, des électrodes métalliques telles que les électrodes 41 et 42 représentées sur la figure 3. Ces électrodes sont disposées par couples tel que 4 pour les électrodes 41 et 42. A titre d'exemple de réalisation, ces couples d'électrodes ont été déposées, comme montré sur la figure 3, selon une ligne.

La distance e1 entre deux électrodes d'un même couple est d'environ 10 microns. La distance e2 entre axes de deux couples d'électrodes est comprise entre 3 et 5 microns.

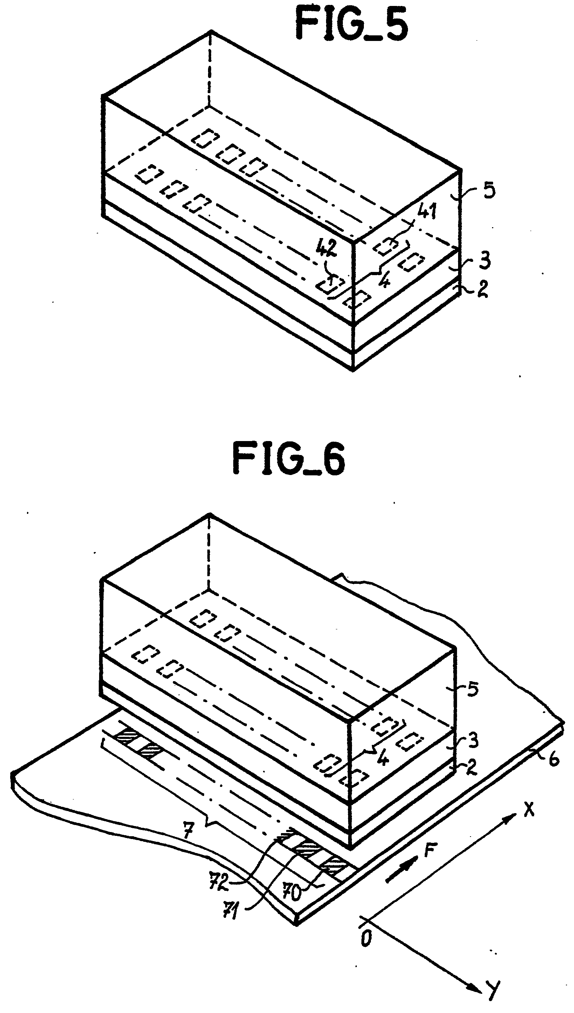

Au cours d'une quatrième phase, un substrat isolant et rigide 5 est fixé sur la surface de la couche 3 portant les électrodes 41, 42. Cette fixation peut se faire par tout procédé connu tel qu'un collage. On obtient ainsi un composant tel que représenté en figure 4.

Au cours d'une cinquième phase, on procède à l'enlèvement du substrat 1 par un procédé adapté à la nature du substrat 1 tel qu'un usinage mécanique ou chimique. L'enlèvement total du substrat 1 n'est pas obligatoire mais il conviendra que l'épaisseur de substrat restant éventuellement n'excède pas 0,5 microns. On obtient alors un capteur tel que représenté en figure 5.

Il est à noter que l'enlèvement du substrat 1 aurait pu se faire entre la deuxième ou troisième phase ou entre la troisième et la quatrième phase.

Selon une variante du procédé de réalisation selon l'invention, le substrat 1 peut être un sel de Baryum et de Fluor ($BaF_2$). Dans ce cas, le dépôt de la couche de matériau ferrimagnétique se fait par pulvérisation cathodique (SPUTTERING). Il convient de plus de prévoir une cristallisation par recuit après ce dépôt et avant le dépôt du matériau semi-conducteur 3.

L'enlèvement du substrat 1 se fera par la suite par dissolution du sel dans une solution adaptée.

On obtient ainsi comme précédemment un capteur tel que représenté en figure 5.

Un tel capteur peut être utilisé comme détecteur d'informations magnétiques enregistrées sur un support magnétique. Ce support peut être une bande magnétique, une carte magnétique, des mémoires à bulles, etc. A titre d'exemple, sur la figure 6, une bande magnétique 6 portant des informations magnétiques 70, 71, 72, etc, arrangées selon une ligne telle que 7 transversale à la bande 6.

La bande 6 se déplace selon la flèche F sous le capteur décrit précédemment. Les informations telles que 70, 71, 72 sont disposées régulièrement selon un pas égal au pas (e2) des couples d'électrodes. Lorsque la bande 6 se déplace, la ligne d'informations 7 passe à proximité de la couche 2 du capteur, à environ 2 à 3 microns, chaque information telle que 71 se trouvant sous un couple d'électrodes tel que 4.

Chaque couple d'électrodes est orientée selon un axe OX. La ligne de couples d'électrodes est orientée selon un axe OY perpendiculaire à l'axe OX. Une ligne d'informations 7 est donc orientée également selon l'axe OY. Une information, telle que 71, induit un champ magnétique qui dans la couche 3, à proximité du couple d'électrodes 4, est parallèle à l'axe OY.

La couche de YIG reporte au niveau du semiconducteur le champ magnétique à la surface de la bande avec un facteur d'échelle qui dépend directement de l'aimantation du grenat. En effet, à une distance d'environ la largeur de piste, la valeur du champ est d'environ 400 G, elle serait dix fois moindre si la couche de YIG n'était pas présente.

On peut analyser la reproduction d'un motif aimanté dans un support magnétique par la configuration des domaines dans une couche de grenat. Si on compare les champs de fuite de la bande et du grenat, on met donc en évidence un facteur d'échelle.

En soumettant la couche de semi-conducteur 3 épitaxiée sur la couche 2 à un champ magnétique par effet MRL (Magnéto Résistif Linéaire) on détecte le champ de fuite des domaines magnétiques de la bande. La forte anisotropie du YIG permet d'augmenter et de canaliser le champ magnétique de fuite des bits à lire.

Dans le cas d'une application à la lecture d'un support magnétique se déplaçant sous le capteur on aura intérêt, lors de l'enlèvement de la couche 1 de substrat d'en laisser une faible épaisseur (0,5 microns par exemple). Cette couche de substrat jouera le rôle de couche résistante mécanique et protégera la couche ferrimagnétique 2.

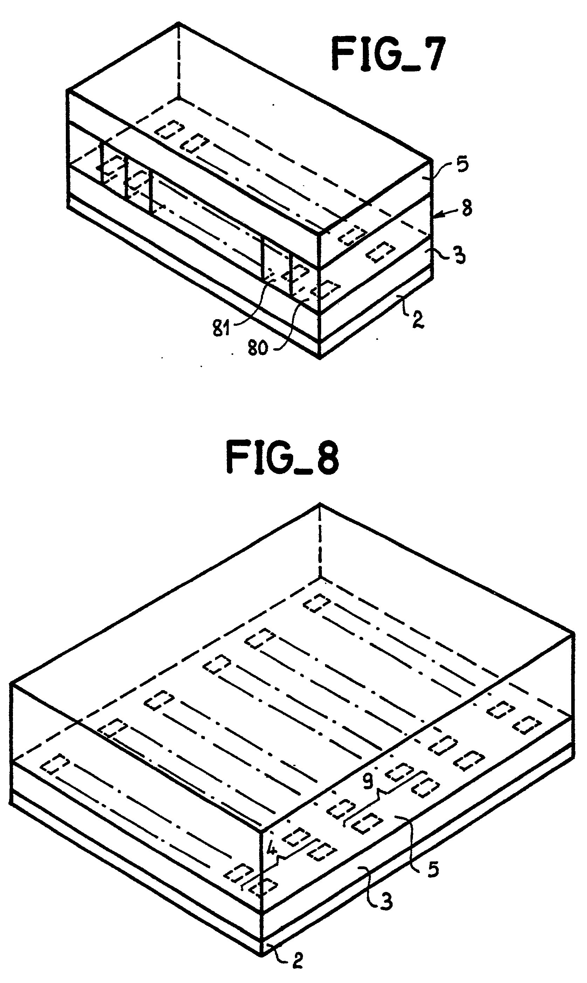

Selon une variante de réalisation représentée en figure 7, on associe à la ligne de couples d'électrodes 4, une ligne à transfert de charge (LTC ou CCD) 8 comportant autant de cellules 80 à 81 qu'il y a de couples d'électrodes, une cellule étant couplée à chaque couple d'électrodes. Une telle structure permettra de faciliter la lecture simultanée d'une ligne d'informations.

Selon une autre variante de réalisation de l'invention, représentée en figure 8, on associe plusieurs capteurs tels que décrits précédemment ce qui permet de lire simultanément une matrice d'informations disposées sur un support d'informations. Selon cet exemple de réalisation, les capteurs ainsi associés sont en fait réalisés en une seule pièce ce qui permet de fabriquer économiquement une tête de lecture adaptée à une utilisation spécifique. C'est ainsi que sur la figure 8, on a représenté une tête de lecture comportant 4 rangées de couples d'électrodes (telles que 4 et 9), disposées sur une même couche de matériau semi-conduteur 3, mais il peut y en avoir beaucoup plus.

Une telle réalisation permet d'être adaptée à la lecture de bits d'informations d'environ 3 microns sur 3 microns, soit des domaines magnétiques détectables de 10 microns au carré de surface.

## Revendications

1. Capteur à effet magnéto résistif linéaire, caractérisé en ce qu'il comprend : une couche d'un matériau semi-conducteur (3) comportant une première face et une deuxième face ; une couche d'un matériau ferrimagnétique (2) recouvrant la première face de la couche de matériau semi-conducteur (3) ; au moins un couple d'électrodes (4) disposé sur la deuxième face de la couche de matériau semi-conducteur (3).

2. Capteur à effet magnéto résistif linéaire selon la revendication 1, caractérisé en ce que la couche de matériau semi-conducteur (3) est constituée de composés des groupes III et V de la classification périodique des éléments.

3. Capteur à effet magnéto résistif linéaire selon la revendication 1, caractérisé en ce que la couche de matériau semi-conducteur (3) est constitué de composés des groupes II et VI de la classification périodique des éléments.

4. Capteur à effet magnéto résistif linéaire selon la revendication 1, caractérisé en ce que la couche de matériau ferrimagnétique (2) est une couche de grenat d'Yttrium et de Fer.

5. Capteur à effet magnéto résistif selon la revendication 1, caractérisé en ce qu'il comporte une couche d'un substrat (1) recouvrant la couche de matériau ferrimagnétique (2).

6. Capteur à effet magnéto résistif selon la revendication 5, caractérisé en ce que la couche de substrat (1) est un grenat de Gadolinium et Gallium.

7. Capteur à effet magnéto résistif selon la revendication 6, dans lequel le grenat de Gallium Gadolinium est dopé au Calcium, Magnésium et Zirconium.

8. Capteur à effet magnéto résistif selon l'une quelconque des revendications précédentes, caractérisé en ce qu'il comprend des couples d'électrodes (4, 9) disposés de façon matricielle sur la deuxième couche de matériau semi-conducteur (3).

9. Procédé de réalisation d'un capteur à effet magnéto résistif selon la revendication 1, caractérisé en ce qu'il comporte les différentes phases suivantes :

     a) une première phase de dépôt d'une couche d'un matériau ferrimagnétique (2) sur un premier substrat (1) ;

     b) une deuxième phase de dépôt d'une couche d'un matériau semi-conducteur (3) sur la couche de matériau ferrimagnétique (2) ;

     c) une troisième phase de dépôt d'électrodes (4) sur la couche de matériau semi-conducteur (3) ;

     d) une quatrième phase de fixation du composant obtenu sur un deuxième substrat en matériau isolant (5) par la face portant les électrodes ;

     e) une cinquième phase d'enlèvement de tout ou partie du premier substrat (1).

10. Procédé selon la revendication 9, caractérisé en ce que la cinquième phase (e) peut être prévue entre la deuxième phase (b) et la troisième phase (c).

11. Procédé selon la revendication 9, caractérisé en ce que la cinquième phase (e) peut être prévue entre la troisième phase (c) et la quatrième phase (d).

12. Procédé selon la revendication 9, caractérisé en ce que le premier substrat est un grenat de gadolinium et gallium et que la couche de matériau ferrimagnétique (2) est une couche de grenat d'Yttrium et de Fer (YIG).

13. Procédé selon la revendication 8, caractérisé en ce que le premier substrat est un grenat de gadolinium et gallium dopé au Calcium, magnésium et zirconium et que la couche de matériau ferrimagnétique est une couche de grenat d'Yttrium et de fer (YIG) dopé au bismuth.

14. Procédé selon la revendication 12, caractérisé en ce que la première phase de dépôt (a) est réalisée par épitaxie en phase liquide.

15. Procédé selon la revendication 12, caractérisé en ce que la première phase de dépôt (a) est réalisée par épitaxie en phase gazeuse.

16. Procédé selon la revendication 12, caractérisé en ce que la première phase de dépôt (a) est réalisée par pulvérisation cathodique.

17. Procédé selon la revendication 12, caractérisé en ce que la cinquième phase (e) d'enlèvement du premier substrat (1) est réalisée par abrasion.

18. Procédé selon la revendication 9, caractérisé en ce que la deuxième phase de dépôt est réalisée par épitaxie en phase vapeur d'organométalliques.

19. Procédé selon la revendication 9, caractérisé en ce que le matériau semi-conducteur (3) est constitué d'éléments des groupes III et V de la classification périodique des éléments.

20. Procédé selon la revendication 9, caractérisé en ce que le matériau semi-conducteur (3) est constitué d'éléments des groupes II et VI de la classification périodique des éléments.

21. Procédé selon la revendication 9, caractérisé en ce que le premier substrat (1) est un sel à base de Baryum et de Fluor et qu'il est prévu entre la première phase et la deuxième phase une phase de recuit.

22. Procédé selon la revendication 21, caractérisé en ce que la première phase de dépôt se fait par épitaxie en phase liquide du matériau ferrimagnétique.

23. Procédé selon la revendication 21, caractérisé en ce que la première phase de dépôt se fait par pulvérisation cathodique.

24. Procédé selon la revendication 21, caractérisé en ce que la cinquième phase (e) d'enlèvement du premier substrat se fait par dissolution du sel.

25. Détecteur de domaines magnétiques comportant un support magnétique (6) comportant au moins un domaine (70) induisant un champ magnétique selon une première direction déterminée, caractérisé en ce qu'il comporte également un capteur réalisé selon l'une quelconque des revendications 1 à 24, comprenant principalement :
- une couche d'un matériau semi-conducteur (3) comportant une première et une deuxième faces ;
- une couche d'un matériau ferrimagnétique (2) déposée sur la première face du matériau semi-conducteur (3) ;
- au moins un couple de deux électrodes (4) disposées sur la deuxième face du matériau semi-conducteur (3), selon une deuxième direction ; ledit capteur étant disposé de telle façon que sa face portant la couche de matériau ferrimagnétique soit à proximité du support magnétique et que la deuxième direction des deux électrodes soit perpendiculaire à la première direction du champ magnétique.

26. Détecteur de domaines magnétiques selon la revendication 25, dans lequel le support magnétique comporte une série de domaines magnétiques ayant une disposition déterminée, caractérisé en ce que ladite deuxième face du matériau semi-conducteur comporte une série de couples d'électrodes ayant une disposition identique à celle des domaines magnétiques.

27. Détecteur de domaines magnétiques selon la revendication 26, caractérisé en ce qu'une électrode des deux de chaque couple d'électrodes sont reliées ensemble de façon à former une électrode commune.

28. Détecteur de domaines magnétique selon la revendication 25, caractérisé en ce que les domaines magnétiques sont disposés à intervalles réguliers selon une ligne et que les couples d'électrodes sont également disposés selon le même intervalle selon une ligne.

29. Détecteur de domaines magnétiques selon la revendication 28, caractérisé en ce qu'il comporte une ligne à transfert de charge disposée parallèlement à la ligne de couples d'électrodes et chaque élément de la ligne à transfert de charge est couplé à un couple d'électrodes.

**Patentansprüche**

1. Sonde mit linearem magnetoresistivem Effekt, dadurch gekennzeichnet, daß sie eine Schicht aus einem Halbleitermaterial (3), die eine erste und zweite Oberfläche besitzt, eine Schicht aus einem ferrimagnetischen Material (2), die die erste Oberfläche der Schicht aus Halbleitermaterial (3) bedeckt, und mindestens ein Paar von Elektroden (4) aufweist, das auf der zweiten Oberfläche der Schicht aus Halbleitermaterial (3) angeordnet ist.

2. Sonde mit linearem magnetoresistivem Effekt nach Anspruch 1, dadurch gekennzeichnet, daß die Schicht aus Halbleitermaterial (3) von Stoffen der Gruppen III und V des Periodensystems der Elemente gebildet wird.

3. Sonde mit linearem magnetoresistivem Effekt nach Anspruch 1, dadurch gekennzeichnet, daß die Schicht aus Halbleitermaterial (3) von Stoffen der Gruppen II und VI des Periodensystems der Elemente gebildet wird.

4. Sonde mit linearem magnetoresistivem Effekt nach Anspruch 1, dadurch gekennzeichnet, daß die Schicht aus ferrimagnetischem Material (2) von Yttrium- und Eisengranat gebildet wird.

5. Sonde mit magnetoresistivem Effekt nach Anspruch 1, dadurch gekennzeichnet, daß sie eine Schicht eines Substrats (1) aufweist, die die Schicht aus ferrimagnetischem Material (2) bedeckt.

6. Sonde mit magnetoresistivem Effekt nach Anspruch 5, dadurch gekennzeichnet, daß die Substratschicht (1) aus Gadolinium- und Galliumgranat besteht.

7. Sonde mit magnetoresistivem Effekt nach Anspruch 6, in der das Gallium-Gadoliniumgranat mit Kalzium, Magnesium und Zirkonium dotiert ist.

8. Sonde mit magnetoresistivem Effekt nach einem beliebigen der vorhergehenden Ansprüche, dadurch gekennzeichnet, daß sie Elektrodenpaare (4, 9) aufweist, die matrixartig auf der zweiten Schicht aus Halbleitermaterial (3) angeordnet sind.

9. Verfahren zur Herstellung einer magnetoresistiven Sonde nach Anspruch 1, dadurch gekennzeichnet, daß es die folgenden Verfahrensschritte aufweist:
a) einen ersten Schritt, in dem eine Schicht eines ferrimagnetischen Materials (2) auf ein erstes Substrat (1) aufgebracht wird;
b) einen zweiten Schritt, in dem eine Schicht aus Halbleitermaterial (3) auf die Schicht aus ferrimagnetischem Material (2) aufgebracht wird;
c) einen dritten Schritt, in dem Elektroden (4) auf die Schicht aus Halbleitermaterial (3) aufgebracht werden;
d) einen vierten Schritt, in dem das so erhaltene Bauteil auf einem zweiten Substrat aus isolierendem Material (5) mit der die Elektroden tragenden Seite befestigt wird;
e) einen fünften Schritt, in dem das erste Substrat (1) ganz oder teilweise entfernt wird.

10. Verfahren nach Anspruch 9, dadurch gekennzeichnet, daß der fünfte Schritt (e) zwischen dem zweiten Schritt (b) und dem dritten Schritt (c) vorgesehen sein kann.

11. Verfahren nach Anspruch 9, dadurch gekennzeichnet, daß der fünfte Schritt (e) zwischen dem dritten Schritt (c) und dem vierten Schritt (d) vorgesehen sein kann.

12. Verfahren nach Anspruch 9, dadurch gekennzeichnet, daß das erste Substrat ein Gadolinium- und Galliumgranat ist und daß die Schicht aus ferrimagnetischem Material (2) von einer Schicht aus Yttrium- und Eisengranat (YIG) gebildet wird.

13. Verfahren nach Anspruch 8, dadurch gekennzeichnet, daß das erste Substrat ein mit Kalzium, Magnesium und Zirkonium dotiertes Gadolinium- und Galliumgranat ist und daß die Schicht aus ferrimagnetischem Material (2) von einer Schicht aus mit Wismut dotiertem Yttrium- und Eisengranat (YIG) gebildet wird.

14. Verfahren nach Anspruch 12, dadurch gekennzeichnet, daß der erste Schritt (a) durch Epitaxie in flüssiger Phase erfolgt.

15. Verfahren nach Anspruch 12, dadurch gekennzeichnet, daß der erste Schritt (a) durch Epitaxie in gasförmiger Phase erfolgt.

16. Verfahren nach Anspruch 12, dadurch gekennzeichnet, daß der erste Schritt (a) durch Kathodenzerstäubung erfolgt.

17. Verfahren nach Anspruch 12, dadurch gekennzeichnet, daß der fünfte Schritt (e), in dem das erste Substrat (1) entfernt wird, durch Abrieb erfolgt.

18. Verfahren nach Anspruch 9, dadurch gekennzeichnet, daß der zweite Schritt durch Epitaxie in organometallischer Dampfphase erfolgt.

19. Verfahren nach Anspruch 9, dadurch gekennzeichnet, daß das Halbleitermaterial (3) aus den Stoffen der Gruppen III und V des Periodischen Systems der Elemente gebildet wird.

20. Verfahren nach Anspruch 9, dadurch gekennzeichnet, daß das Halbleitermaterial (3) aus den Stoffen der Gruppen II und VI des Periodischen Systems der Elemente gebildet wird.

21. Verfahren nach Anspruch 9, dadurch gekennzeichnet, daß das erste Substrat (1) ein Salz auf der Basis von Barium und Fluor ist und daß zwischen dem ersten Schritt und dem zweiten Schritt eine Wärmebehandlung erfolgt.

22. Verfahren nach Anspruch 21, dadurch gekennzeichnet, daß der erste Schritt durch Epitaxie des ferrimagnetischen Materials in flüssiger Phase erfolgt.

23. Verfahren nach Anspruch 21, dadurch gekennzeichnet, daß der erste Schritt durch Kathodenzerstäubung erfolgt.

24. Verfahren nach Anspruch 21, dadurch gekennzeichnet, daß der fünfte Schritt (e), in dem das erste Substrat entfernt wird, durch Auflösung des Salzes erfolgt.

25. Magnetdomänendetektor mit einem magnetischen Träger (6), der mindestens eine ein Magnetfeld gemäß einer ersten vorbestimmten Richtung induzierenden Domäne (70) aufweist, dadurch gekennzeichnet, daß er weiter eine Sonde nach einem beliebigen der Ansprüche 1 bis 24 enthält, die hauptsächlich

– eine Schicht aus einem Halbleitermaterial (3) mit einer ersten und zweiten Oberfläche;

– eine Schicht aus einem ferrimagnetischen Material (2), die auf die erste Oberfläche des Halbleitermaterials (3) aufgebracht ist;

– mindestens ein Paar von zwei Elektroden (4) aufweist, die auf die zweite Oberfläche des Halbleitermaterials (3) gemäß einer zweiten Richtung aufgebracht sind, wobei die Sonde so angeordnet ist, daß ihre die Schicht auf ferrimagnetischem Material tragende Oberfläche in der Nähe des magnetischen Trägers liegt und daß die zweite Richtung, entlang der die beiden Elektroden angebracht sind, senkrecht zur ersten Richtung liegt, in der das Magnetfeld verläuft.

26. Magnetdomänendetektor nach Anspruch 25, in dem der magnetische Träger eine Reihe von magnetischen Domänen einer vorgegebenen Anordnung enthält, dadurch gekennzeichnet, daß die zweite Oberfläche des Halbleitermaterials eine Reihe von Elektrodenpaaren aufweist, deren Anordnung der der Magnetdomänen gleicht.

27. Magnetdomänendetektor nach Anspruch 26, dadurch gekennzeichnet, daß eine der beiden Elektroden jedes Elektrodenpaars so angeschlossen ist, daß sich eine gemeinsame Elektrode ergibt.

28. Magnetdomänendetektor nach Anspruch 25, dadurch gekennzeichnet, daß die Magnetdomänen in regelmäßigen Abständen entlang einer Zeile angeordnet sind und daß die Elektrodenpaare ebenfalls in denselben Abständen entlang einer Zeile angeordnet sind.

29. Magnetdomänendetektor nach Anspruch 28, dadurch gekennzeichnet, daß er eine Ladungstransferleitung enthält, die parallel zur Zeile der Elektrodenpaare verläuft, und daß jedes Element der Ladungstransferleitung an ein Elektrodenpaar gekoppelt ist.

**Claims**

1. A probe based on the linear magnetoresistive effect, characterized in that it comprises: a layer of a semiconductor material (3) including a first and a second surface; a layer of a ferrimagnetic material (2) deposited on the first surface of the layer of semiconductor material (3); at least one couple of electrodes (4) located on the second surface of the layer of semiconductor material (3).

2. A probe based on the linear magnetoresistive effect according to claim 1, characterized in that the layer of semiconductor material (3) is constituted of elements of the groups III and V Mendeleev's Table.

3. A probe based on the linear magnetoresistive effect according to claim 1, characterized in that the layer of semiconductor material (3) is constituted of elements of the groups II and VI of Mendeleev's Table.

4. A probe based on the linear magnetoresistive effect according to claim 1, characterized in that the layer of ferrimagnetic material (2) is made of yttrium and iron garnet.

5. A probe based on magnetoresistive effect according to claim 1, characterized in that it comprises a layer of a substrate (1) laid on the layer of ferrimagnetic material (2).

6. A probe based on the magnetoresistive effect according to claim 5, characterized in that the substrate layer (1) is made of gadolinium and gallium garnet.

7. A probe based on the magnetoresistive effect according to claim 6, in which the gallium-gadolinium garnet is doped with calcium, magnesium and zirconium.

8. A probe based on the magnetoresistive effect according to any one of the preceding claims, characterized in that it comprises pairs of electrodes (4, 9) disposed in a matrix arrangement on the second layer of semiconductor material (3).

9. A method of manufacturing a probe based on the magnetoresistive effect according to claim 1, characterized in that it comprises the different steps as follows:

a) a first step of depositing a layer of ferrimagnetic material (2) on a first substrate (1);

b) a second step of depositing a layer of semiconductor material (3) on the layer of ferrimagnetic material (2);

c) a third step of depositing electrodes on the layer of semiconductor material (3);

d) a fourth step of securing the component obtained on a second substrate made of insulating material (5) via the surface which bears the electrodes;

e) a fifth step of totally or partially eliminating the first substrate (1).

10. A method according to claim 9, characterized in that the fifth step (e) may be performed between the second step (b) and the third step (c).

11. A method according to claim 9, characterized in that the fifth step (e) may be performed between the third step (c) and the fourth step (d).

12. A method according to claim 9, characterized in that the first substrate is made of gadolinium and gallium garnet and that the layer of ferrimagnetic material (2) is a layer of yttrium and iron garnet (YIG).

13. A method according to claim 8, characterized in that the first substrate is made a gadolinium and gallium garnet which is doped with calcium, magnesium and zirconium, and that the layer of ferrimagnetic material (2) is a layer of yttrium and iron garnet (YIG), which is doped with bismuth.

14. A method according to claim 12, characterized in that the first step (a) is realized by liquid-phase epitaxy.

15. A method according to claim 12, characterized in that the first step (a) is realized by gaseous-phase epitaxy.

16. A method according to claim 12, characterized in that the first step (a) is realized by cathode sputtering.

17. A method according to claim 12, characterized in that the fifth step (e), during which the first substrate (1) is eliminated, is obtained by abrasion.

18. A method according to claim 9, characterized in that the second step is realized by vapour-phase epitaxy using vapours of organometallic materials.

19. A method according to claim 9, characterized in that the semiconductor material (3) is constituted of elements of the groups III and V of Mendeleev's Table.

20. A method according to claim 9, characterized in that the semiconductor material (3) is constituted of elements of the groups II and VI of Mendeleev's Table.

21. A method according to claim 9, characterized in that the first substrate (1) is a salt based on barium and fluor and that a tempering step is performed between the first and the second step.

22. A method according to claim 21, characterized in that the first step is realized by liquid-phase epitaxy using a ferrimagnetid material.

23. A method according to claim 22, characterized in that the first step is performed by cathode sputtering.

24. A method according to claim 21, characterized in that the fifth step (e), during which the first substrate is eliminated, is realized by dissolving the salt.

25. A magnet domain detector comprising a magnetic support (6) having at least one domain (70) which induces a magnetic field according to a predetermined first direction, characterized in that it further comprises a probe obtained according to any one of claims 1 to 24, and mainly comprising:

– a layer of semiconductor material (3) having a first and a second surface;

– a layer of ferrimagnetic material (2) deposited on the first surface of the semiconductor material (3);

– at least one couple of two electrodes (4) disposed on the second surface of the semiconductor material (3) along a second direction, said probe being disposed in such a way that the surface bearing the ferrimagnetic material layer is close to the magnetic support and that the second direction of the two electrodes is perpendicular to the first direction of the magnetic field.

26. A magnet domain detector according to claim 25, in which the magnetic support comprises a series of magnetic domains of a predetermined disposition, characterized in that said second surface of the semiconductor material comprises a series of electrode pairs having the same disposition as the magnetic domains.

27. A magnet domain detector according to claim 26, characterized in that one electrode of each pair of electrodes is connected together in order to constitute a common electrode.

28. A magnet domain detector according to claim 25, characterized in that the magnetic domains are disposed at regular intervals along a line and that the pairs of electrode are also disposed at identical intervals along a line.

29. A magnet domain detector according to claim 28, characterized in that it comprises a charge transfer line disposed parallelly to the line of electrode pairs and that each element of the charge transfer line is coupled to one pair of electrodes.

FIG_1

$h1$

1

2

FIG_2

$h2$
$h1$

3

2

1

$e1$

$e2$

FIG_3

41

4

42

3

2

1

5

FIG_4

4

3

2

1

# FIG_5

# FIG_6

FIG_7

FIG_8